# EUROPEAN PATENT APPLICATION

(11) **EP 4 110 027 A1**
(43) Date of publication of application: **28.12.2022**
(21) Application number: 22167677.8
(22) Date of filing: 11.04.2022
(51) Int. Cl.: H05K 7/20, H01L 21/48

(54) **HEAT DISSIPATION DEVICE FOR LED LIGHT STRIP OF TELEVISION**

(30) Priority: 25.06.2021 CN 202121438365 U
(71) Applicant: Guangdong Envicool Technology Co., Ltd., Sanjiao Town, Zhongshan Guangdong 528400 (CN)
(72) Inventor: WANG, Ye, Zhongshan, 528400 (CN); SU, Hongmeng, Zhongshan, 528400 (CN); ZHANG, Jing, Zhongshan, 528400 (CN)
(74) Representative: Potter Clarkson

(57) **Abstract**

A heat dissipation device for an LED light strip of a television is provided, including a heat dissipation substrate and a heat dissipation plate. A mounting surface of the heat dissipation substrate is provided with a clamping opening for mounting the light strip and a mounting groove extending along a length direction. The light strip may be arranged on the mounting surface along the length direction through the clamping opening. The heat dissipation plate is filled with a refrigerant working medium, one side of the heat dissipation plate is fixed in the mounting groove, and the heat dissipation plate extends along the length direction of the heat dissipation substrate.

## Description

### FIELD

The present application relates to the technical field of heat dissipation for electronic equipment, and in particular to a heat dissipation device for an LED light strip of a television.

### BACKGROUND

With the development of science and technology, the definition requirements of televisions are continuously increased, and the power of luminous LED strips in televisions also increases. The heat dissipation requirements of the televisions cannot be met by using an extruded aluminum plate as a heat dissipation plate to conduct the heat of the LED light strips the heat dissipation plate in a thermally conductive manner, and then transfer the heat to the television housing via convection.

In a situation that a metal heat dissipation plate in the form of an inflated plate is adopted, through the phase change diffusion of the medium, heat is rapidly dissipated to the whole heat dissipation plate, the temperature of the heat dissipation plate is uniform, the technology is mature, easy to manufacture and low in cost. However, since the LED light strip is arranged above a bending portion of the heat dissipation device, and the cavity of the metal heat dissipation plate is limited to an inside of the main body portion, the heat is conducted from the light strip to the bending portion of the heat dissipation device, and then from the bending portion to the main body portion, and the heat is dissipated through the phase change of the main body portion. In this case, the transfer path is long, the transfer heat resistance is large, and the heat dissipation effect is poor.

Therefore, a technical problem to be addressed by those skilled in the art is to improve the heat dissipation performance.

### SUMMARY

An object of the present application is to provide a heat dissipation device for an LED light strip of a television, to improve the heat dissipation performance.

To achieve the above object, the following solutions are provided according to the present application.

A heat dissipation device for an LED light strip of a television includes a heat dissipation substrate and a heat dissipation plate, where the heat dissipation substrate is provided with a clamping opening for mounting the LED light strip and a mounting groove extending along a length direction of the heat dissipation substrate; the heat dissipation plate is filled with a refrigerant working medium, one side of the heat dissipation plate is fixedly inserted in the mounting groove, and the heat dissipation plate extends along the length direction of the heat dissipation substrate.

In an embodiment, the heat dissipation plate is a thermally uniform plate, an inflated plate, or a thermosyphon plate.

In an embodiment, the heat dissipation plate is processed by inflation or welding.

In an embodiment, the heat dissipation substrate is a copper heat dissipation substrate, an aluminum heat dissipation substrate, or an alloy heat dissipation substrate.

In an embodiment, the heat dissipation substrate is connected to the heat dissipation plate by welding, pressing, or riveting.

In an embodiment, the number of the heat dissipation plate is multiple, and the multiple heat dissipation plates are spaced apart on the heat dissipation substrate.

In an embodiment, the heat dissipation substrate, the clamping opening and the mounting groove provided on the heat dissipation substrate are formed by integral molding, cutting, or die casting.

In an embodiment, the number of the clamping opening is multiple.

In an embodiment, the multiple clamping openings are arranged along the length direction.

With the heat dissipation device for the LED light strip of the television according to the present application, in case that the LED light strip is working, the heat generated is first transferred to the heat dissipation substrate, and then transferred to a lower portion of the heat dissipation plate via a connecting portion between the heat dissipation substrate and the heat dissipation plate. Since the refrigerant working medium inside the heat dissipation plate is in a saturated state, when the liquid refrigerant working medium is heated, a boiling process occurs inside the heat dissipation plate and the liquid refrigerant working medium becomes a gaseous refrigerant working medium. Meanwhile, under the action of gravity, the gaseous working medium moves upwards and releases heat to an upper portion of the heat dissipation plate through phase change of condensation. The condensed liquid refrigerant working medium flows, under the action of gravity, along the inner surface of the heat dissipation plate to the lower portion of the heat dissipation plate, thus realizing the circulation of the refrigerant working medium. Because the heat transfer is performed inside the heat dissipation plate through phase change and diffusion movement of the refrigerant working medium, the temperature difference between the upper and lower portions of the heat dissipation plate is small, and the fin efficiency is high, which can greatly improve the heat dissipation efficiency of the heat dissipation device, and thereby ensuring that the temperature of the heat source is in the ideal working range. As the LED light strip and the heat dissipation plate are both arranged on the heat dissipation substrate, the heat resistance along the path between the light strip and the heat dissipation plate is reduced, which improves the heat dissipation effect compared with the conventional technology.

### BRIEF DESCRIPTION OF THE DRAWINGS

For more clearly illustrating embodiments of the present application or the technical solutions in the conventional technology, drawings referred to describe the embodiments or the conventional technology will be briefly described hereinafter. Apparently, the drawings in the following description are only some examples of the present application, and for those skilled in the art, other drawings may be obtained based on these drawings without any creative efforts.
FIG. 1 is a schematic perspective view showing the structure of a heat dissipation device for an LED light strip of a television according to an embodiment of the present application;
FIG. 2 is a schematic front view of the heat dissipation device according to the embodiment of the present application;
FIG. 3 is a schematic top view of the heat dissipation device according to the embodiment of the present application;
FIG. 4 is a schematic side view of the heat dissipation device according to the embodiment of the present application; and
FIG. 5 is an exploded schematic view showing the structure of the heat dissipation device according to the embodiment of the present application.

Reference numerals in the drawings:

| | | | |
|---|---|---|---|
| 100 | heat dissipation substrate, | 200 | heat dissipation plate, |
| 101 | clamping opening, | 102 | mounting groove. |

### DETAILED DESCRIPTION OF THE EMBODIMENTS

In order to improve the heat dissipation performance of the heat dissipation device of electronic components, there are mainly three existing solutions, the first solution is to improve the material composition of the heat dissipation plate, to improve the thermal conductivity of the heat dissipation plate through the combination and stacking of different material layers, so as to enhance the heat exchange efficiency of the heat dissipation device. The second solution is to improve the structure of the heat dissipation plate, to increase the convection heat transfer effect of the heat dissipation plate by adding fins, providing openings, etc., so as to enhance the heat transfer efficiency of the heat dissipation device. The third solution is to replace the original heat dissipation plate with an inflated plate, and mount the LED light strip at a bending portion at a lower side of the lower layered aluminum plate.

In order to meet the heat dissipation effect, make up for the decrease in heat dissipation performance caused by the uneven temperature among the parts of the heat dissipation plate, the main solution is to improve the heat dissipation structure of the heat dissipation plate, provide the fins, to improve the thermal conductivity or convection heat exchange effect of the heat dissipation plate, so as to enhance the heat transfer efficiency of the heat dissipation device. As a result, the size and weight of the heat dissipation plate increase, which does not meet the requirements of light weight and convenience. Besides, regarding improvement of the material composition, it is costly, and the obtained heat dissipation plate is fragile, which also greatly increases the cost.

An object of the present application is to provide a heat dissipation device for an LED light strip of a television, to improve the heat dissipation performance.

In order to make those skilled in the art better understand technical solutions of the present application, the present application will be described in detail hereinafter in conjunction with the drawings and specific embodiments.

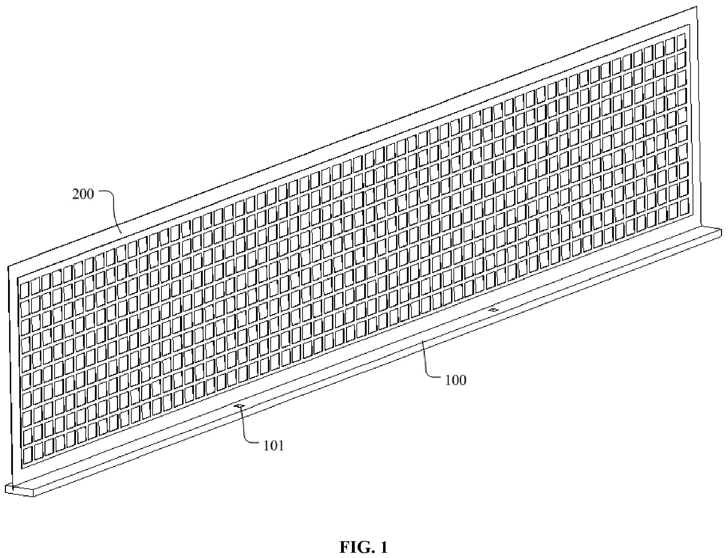

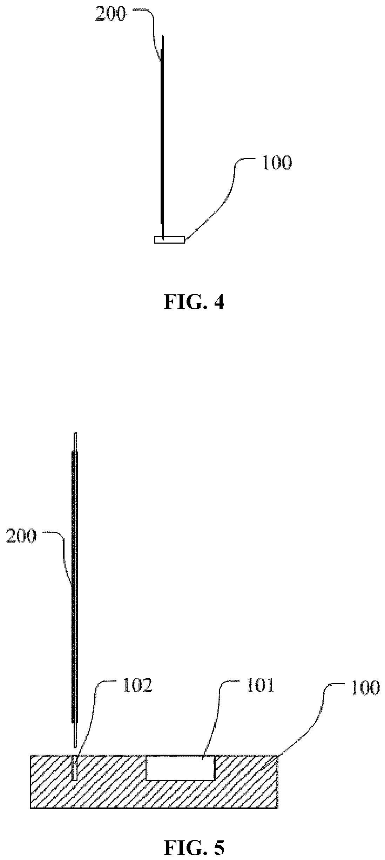

Referring to FIG. 1 to FIG. 5, a heat dissipation device for an LED light strip of a television is provided according to the present application, which includes a heat dissipation substrate 100 and a heat dissipation plate 200. The heat dissipation substrate 100 is provided with a clamping opening 101 for mounting the LED light strip and a mounting groove 102 extending along a length direction of the heat dissipation substrate 100; the heat dissipation plate 200 is filled with a refrigerant working medium, the heat dissipation plate 200 is fixedly inserted in the mounting groove 102 and extends along the length direction of the heat dissipation substrate 100.

With the heat dissipation device according to the present application, when the LED strip operates, the heat generated is first transferred to the heat dissipation substrate 100, and then transferred to a lower portion of the heat dissipation plate 200 via a connecting portion between the heat dissipation substrate 100 and the heat dissipation plate 200. Since the refrigerant working medium inside the heat dissipation plate 200 is in a saturated state, when the liquid refrigerant working medium is heated, a boiling process occurs inside the heat dissipation plate 200 and the liquid refrigerant working medium becomes a gaseous refrigerant working medium. Meanwhile, under the action of gravity, the gaseous refrigerant working medium moves upwards and releases heat to an upper portion of the heat dissipation plate 200 through phase change of condensation. The condensed liquid refrigerant working medium flows, under the action of gravity, along the inner surface of the heat dissipation plate 200 to the lower portion of the heat dissipation plate 200, thus realizing the circulation of the refrigerant working medium. Because the heat transfer is performed inside the heat dissipation plate through phase change and diffusion movement of the refrigerant working medium, the temperature difference between the upper and lower portions of the heat dissipation plate 200 is small, and the fin efficiency is high, which can greatly improve the heat dissipation efficiency of the heat dissipation device, and thereby ensuring that the temperature of the heat source is in the ideal working range. As the LED light strip and the heat dissipation plate 200 are both arranged on the heat dissipation substrate 100, the heat resistance along the path between the strip and the heat dissipation plate 200 is reduced, which improves the heat dissipation effect compared with the conventional technology.

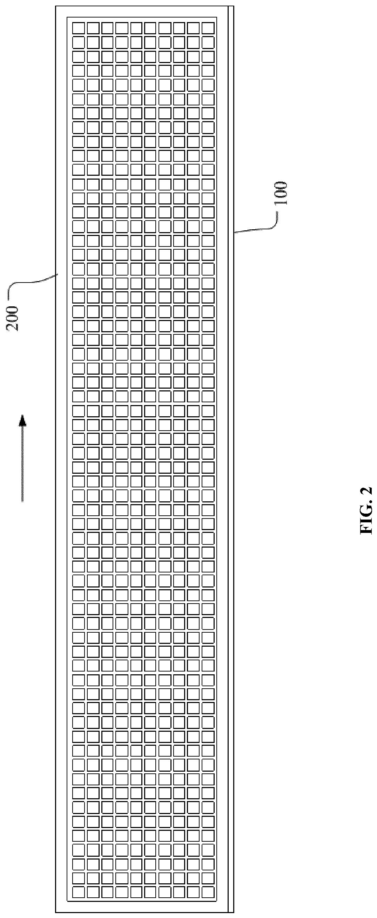

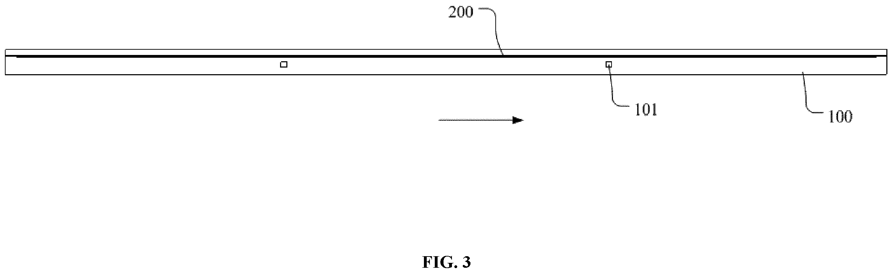

It should be noted that the length direction mentioned in the present application is a direction in which the LED light strip extends, as shown by the arrow in FIG. 2 and FIG. 3. The heat dissipation plate 200 and the heat dissipation substrate 100 are arranged to extend in the length direction, to realize the heat dissipation of the entire LED light strip.

The heat dissipation plate 200 is a thermally uniform plate, an inflated plate, or a thermosiphon plate, which are all plate-shaped structures in which two-phase heat transfer is performed, and heat dissipation is realized through phase change. In the actual manufacturing process, the heat dissipation plate 200 is manufactured by inflation or welding.

The heat dissipation substrate 100 is made of materials with good thermal conductivity, such as cooper, aluminum, alloy, etc. That is, the heat dissipation substrate 100 may be copper heat dissipation substrate, aluminum heat dissipation substrate, or alloy heat dissipation substrate.

There are many ways to fix the heat dissipation substrate 100 and the heat dissipation plate 200, For example, the heat dissipation substrate 100 and the heat dissipation plate 200 are connected by welding, pressing, or riveting.

During the mounting process, the heat dissipation plate 200 is mounted in the mounting groove 102, and then the heat dissipation plate 200 and the heat dissipation plate 200are fixed together by welding or pressing. Since the heat dissipation plate 200 is placed in the mounting groove 102, there is no bending structure at the portion where the heat dissipation plate 200 is connected with the heat dissipation substrate 100, thus reducing the heat resistance along the path.

The heat dissipation substrate 100 is a cylindrical structure, a prism structure, and other structures that may extend along a certain direction. In an embodiment, the heat dissipation substrate 100 is a cuboid structure, and one side surface of the heat dissipation substrate 100 is a mounting surface.

Multiple heat dissipation plates 200 are provided, and the multiple heat dissipation plates 200 are spaced apart on the heat dissipation substrate 100. The solution of providing the multiple heat dissipation plates 200 may improve the heat dissipation efficiency, which is suitable for the LED light strip with large amount of heat generation. Of course, the number of the heat dissipation plates 200 may be appropriately determined according to the number of the LED light strip and the amount of heat generation.

The heat dissipation substrate 100 is provided with the clamping opening 101 and the mounting groove 102. The clamping opening 101 and the mounting groove 102 may be processed by cutting, milling, forging, die-casting or other processes after the heat dissipation substrate 100 is processed; or the heat dissipation substrate 100 may be integrally formed with the clamping opening 101 and the mounting groove 102.

The number of clamping opening 101 may be one or more, any structure that can realize the installation of the light strip on the heat dissipation substrate 100 can be understood as the clamping opening 101. In an embodiment, the number of clamping openings 101 is multiple.

In a case that multiple clamping openings 101 are provided, the multiple clamping openings 101 are arranged along the length direction or multiple clamping openings 101 are arranged in a concentrated manner.

It should be noted that, in this specification, the terms "first", "second", "third", "fourth" and the like (if present) in the description, claims and drawings are used for distinguishing between similar parts and are not intended to describe a specific sequence or precedence order. Besides, terms "include", "comprise" or any other variations are intended to cover non-exclusive "include", thus a process, a method, an object or a device including a series of factors not only include the listed factors, but also include other factors not explicitly listed, or also include inherent factors of the process, the method, the object or the device. Without more limitations, a factor defined by a sentence "include one... " does not exclude a case that there is another same factor in the process, the method, the object or the device including the described factor.

The above embodiments in this specification are described in a progressive manner. Each of the embodiments is mainly focused on describing its differences from other embodiments, and references may be made among these embodiments with respect to the same or similar portions among these embodiments.

Based on the above description of the disclosed embodiments, those skilled in the art are capable of carrying out or using the present application. It is obvious for those skilled in the art to make many modifications to these embodiments. The general principle defined herein may be applied to other embodiments without departing from the scope of the present application. Therefore, the present application is not limited to the embodiments illustrated herein, but should be defined by the broadest scope consistent with the principle and novel features disclosed herein.

## Claims

1. A heat dissipation device for an LED light strip of a television, comprising:
a heat dissipation substrate and a heat dissipation plate, wherein
the heat dissipation substrate is provided with a clamping opening for mounting the LED light strip and a mounting groove extending along a length direction of the heat dissipation substrate; and
the heat dissipation plate is configured to be filled with a refrigerant working medium, the heat dissipation plate is fixedly inserted in the mounting groove and extends along the length direction of the heat dissipation substrate.

2. The heat dissipation device according to claim 1, wherein the heat dissipation plate is a thermally uniform plate, an inflated plate or a thermosyphon plate.

3. The heat dissipation device according to claim 1, wherein the heat dissipation plate is processed by inflation or welding.

4. The heat dissipation device according to claim 1, wherein the heat dissipation substrate is a copper heat dissipation substrate, an aluminum heat dissipation substrate, or an alloy heat dissipation substrate.

5. The heat dissipation device according to claim 1, wherein the heat dissipation substrate is connected to the heat dissipation plate by welding, pressing, or riveting.

6. The heat dissipation device according to claim 1, wherein the number of the heat dissipation plate is plural, and the plurality of heat dissipation plates are spaced apart on the heat dissipation substrate.

7. The heat dissipation device according to claim 1, wherein the heat dissipation substrate, the clamping opening and the mounting groove provided on the heat dissipation substrate are formed by integral molding, cutting, or die casting.

8. The heat dissipation device according to claim 1, wherein the number of the clamping opening is plural.

9. The heat dissipation device according to claim 8, wherein the plurality of clamping openings are arranged along the length direction.
